# EUROPEAN PATENT SPECIFICATION

(11) **EP 1 665 399 B1**
(45) Date of publication and mention of the grant of the patent: **18.11.2009**
(21) Application number: 04769866.7
(22) Date of filing: 27.08.2004
(51) Int. Cl.: H01L 33/00, C09K 11/59

(54) **WHITE LIGHT EMITTING LIGHTING SYSTEM**
WEISSES LICHT EMITTIERENDES BELEUCHTUNGSSYSTEM
INSTALLATION D'ECLAIRAGE EMETTANT DE LA LUMIERE BLANCHE

(30) Priority: 15.09.2003 EP 03103384
(43) Date of publication of application: 07.06.2006
(73) Proprietor: Koninklijke Philips Electronics N.V., 5621 BA Eindhoven (NL)
(72) Inventor: HILDENBRAND, Volker, D., NL-5656 AA Eindhoven (NL)
(74) Representative: Bosma, Rudolphus Hubertus Antonius
(86) International application number: PCT/IB2004/051582
(87) International publication number: WO 2005/027231

(56) References cited:
- DE-A1- 1 801 486
- GB-A- 544 160
- US-A1- 2003 085 853
- PATENT ABSTRACTS OF JAPAN vol. 2003, no. 03, 5 May 2003 (2003-05-05) & JP 2002 332481 A (SUMITOMO CHEM CO LTD), 22 November 2002 (2002-11-22)

## Description

The invention relates to a white light emitting lighting system, comprising a blue or UV light emitting diode and a coating comprising a yellow luminescent phosphor.

Conventional LED lighting systems for producing white light typically comprise either LEDs or phosphor-LEDs. Lighting systems which use LEDs produce white light by combining various combinations of red, green, and blue LEDs. Phosphor-LED based lighting systems produce white light by using one or more various luminescent phosphor materials on top of a blue or UV light LED to convert a portion of the emitted blue or UV light into light of a longer wavelength. If a blue light LED is used, the phosphor should emit yellow light to obtain white light. If a UV light LED is used, an additional phosphor should be applied which converts part of the UV light into blue light, for instance a BaMgAl₁₀O₁₇:Eu phosphor.

An advantage of using a UV light LED with blue and yellow luminescent phosphor as opposed to a blue light LED with yellow luminescent phosphor is, that the first is less vulnarable to colour variations caused by variations in the quantity of phosphor present in the LED.

In general it is easier to produce white light with phosphor-LED based lighting systems as compared with LED based lighting systems because phosphor-LEDs do not require mixing and have lower material costs (they are inherently mixed).

It is known to use a blue LED with the yellow emitting phosphor being a cerium doped yttrium aluminum garnet Y₃Al₅O₁₂:Ce, also referred to as YAG:Ce. GB 544 160 A discloses europium doped silicates and mixed silicates used in electric discharge lamps.

The object of the invention is to provide an alternative yellow emitting phosphor to be used with blue or UV LEDs in order to obtain a white light LED, and which may have better colour or efficiency properties.

Thereto the invention provides a blue or UV light emitting diode and a coating comprising a yellow luminescent Sr_{2-x-y-z}CayBaSiO₄:Euₓ phosphor, and wherein 0<x<=0.06 and 0<(3y+z)<=0.5. Peferably 0<x<=0.04, 0<=y<=0.1 and/or 0<z<=0.3. More preferably 0.01 <=x<=0.03, 0.01<=y<=0.06 and/or 0.03<=z<=0.25. Tests have shown that a strontium silicate phosphor containing small amounts of Ca, Ba and Eu emit at a peak emission wavelength greater than 550 nm (yellow), which makes such phosphor suitable for the desired purpose.

According to the present invention the amount of Sr is predominant, resulting in a peak emission wavelength of greater than 550 nm (yellow), which makes it possible to mix it with blue light, and to obtain a white light composed of two color components only.

The advantages, nature, and various additional features of the invention will appear more fully upon consideration of the illustrative embodiments now to be described in detail in connection with accompanying drawing wherein:
Fig. 1 is a sectional view of a typical phosphor-LED used in the lighting system of the invention.
Fig. 2 is a graph showing the peak emission wavelengths of phosphor examples.

It should be understood that the drawing is for purposes of illustrating the concepts of the invention and is not to scale.

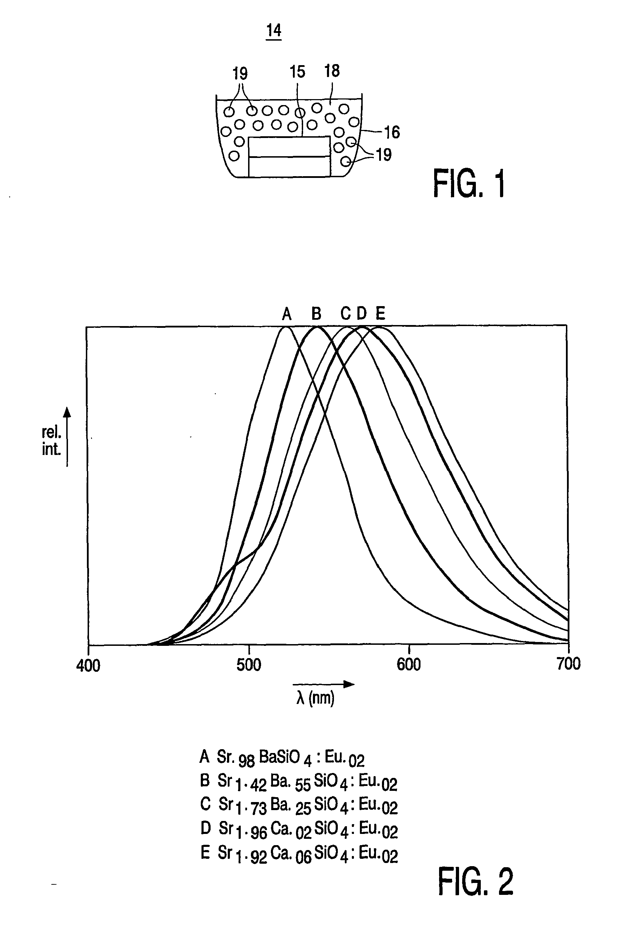

According to Fig. 1 the lighting system of the invention generally comprises a phosphor-LED 14 consisting of a blue or UV LED and at least one phosphor which emits at certain light spectral wavelength (colour), to produce white light. The LED 14 is conventionally constructed using standard AlInGaN or AlInGaP processing and comprises a LED chip 15 mounted in a reflective metal dish or reflector 16 filled with a transparent epoxy 18. The epoxy 18 filling the reflector 16 contains grains 19 of one or more types of luminescent phosphor materials mixed homogeneously therein. The phosphor grains 19 convert a portion of the light emitted by the LED chip 15 to light of a different spectral wavelength.

Fig. 2 shows the peak emission wavelengths of five tested examples of phosphor materials of the type Sr_{2-x-y-z}CayBa_{z}SiO₄:Euₓ. According to the invention examples C, D and E can be used in combination with a blue light emitting diode, or alternatively with a UV light emitting diode and a blue luminescent phosphor, to produce white light.

## Claims

1. A white light emitting lighting system, comprising a blue or UV light emitting diode and a coating comprising a yellow luminescent phosphor having a peak emission wavelength greater than 550 nm, wherein the phosphor comprises a Sr_{2-x-y-z}Ca_{y}Ba_{z}SiO₄:Euₓ phosphor, and wherein 0<x<=0.06 and 0<(3y+z)<=0.5.

2. The system according to claim 1, wherein 0<x<=0.04, preferably 0.01 <=x<=0.03.

3. The system according to claim 1 or 2, wherein 0<y<=0.1, preferably 0.01 <=y<=0.06.

4. The system according to claim 1, 2 or 3, wherein 0<=z<=0.3, preferably 0.03<=z<=0.25.

5. The system according to any of the previous claims 1-4, wherein the phosphor further comprises a cerium doped yttrium aluminium garnet (YAG:Ce) phosphor.

6. The system according to any of the previous claims 1-5, wherein the diode is a UV light emitting diode, and the coating further comprises a blue luminescent phosphor.

7. The system according to claim 6, wherein the blue luminescent phosphor comprises a BaMgAl₁₀O₁₇:Eu phosphor.

## Patentansprüche

1. Weißes Licht emittierendes Beleuchtungssystem mit einer, blaues oder UV-Licht emittierenden Diode und einer Beschichtung mit einem gelb lumineszierenden Leuchtstoff mit einer Spitzen-Emissionswellenlänge größer als 550 nm, wobei der Leuchtstoff einen Sr_{2-x-y-z}Ca_{y}Ba_{z}SiO₄:Euₓ-Leuchtstoff umfasst, und wobei 0<x<=0,06 und 0<(3y+z)<=0,5.

2. System nach Anspruch 1, wobei 0<x<=0,04, vorzugsweise 0,01<=x<=0,03.

3. System nach Anspruch 1 oder 2, wobei 0<y<=0,1, vorzugsweise 0,01 <=y<=0,06.

4. System nach Anspruch 1, 2 oder 3, wobei 0<=z<=0,3, vorzugsweise 0,03<=z<=0,25.

5. System nach einem der vorangegangenen Ansprüche 1-4, wobei der Leuchtstoff weiterhin einen Cer-dotierten Yttrium-Aluminium-Granat-(YAG:Ce) Leuchtstoff umfasst.

6. System nach einem der vorangegangenen Ansprüche 1-5, wobei die Diode eine UV-Licht emittierende Diode ist und die Beschichtung weiterhin einen blau lumineszierenden Leuchtstoff umfasst.

7. System nach Anspruch 6, wobei der blau lumineszierende Leuchtstoff einen BaMgAl₁₀O₁₇:Eu-Leuchtstoff umfasst.

## Revendications

1. Système d'éclairage émettant de la lumière blanche, comprenant une diode électroluminescente bleue ou ultraviolette et une couche de revêtement comprenant un phosphore luminescent jaune ayant une longueur d'onde d'émission de crête qui est supérieure à 550 nm, dans lequel le phosphore comprend un phosphore de Sr_{2-x-y-z}Ca_{y}Ba_{z} SiO₄:Euₓet dans lequel 0<x<=0,06 et 0<(3y+z)<=0,5.

2. Système selon la revendication 1, dans lequel 0<x<=0,04, de préférence 0,01 <=x<=0,03.

3. Système selon la revendication 1 ou selon la revendication 2, dans lequel 0<y<=0,1, de préférence 0,01<=y<=0,06.

4. Système selon les revendications 1, 2 ou 3, dans lequel 0<=z<=0,3, de préférence 0,03<=z<=0,25.

5. Système selon l'une quelconque des revendications précédentes 1 à 4, dans lequel le phosphore comprend encore un phosphore grenat d'aluminium et d'yttrium dopé au cérium (YAG:Ce).

6. Système selon l'une quelconque des revendications précédentes 1 à 5, dans lequel la diode est une diode électroluminescente ultraviolette et dans lequel la couche de revêtement comprend encore un phosphore luminescent bleu.

7. Système selon la revendication 6, dans lequel le phosphore luminescent bleu comprend un phosphore de BaMgAl₁₀Oi₇:Eu.
